Europäisches Patentamt

European Patent Office

Office européen des brevets

(11) Publication number: **0 307 067 A2**

## (12) EUROPEAN PATENT APPLICATION

(21) Application number: 88302683.3

(51) Int. Cl.⁴: **H01H 85/22**

(22) Date of filing: 25.03.88

(30) Priority: 11.09.87 US 96174

(43) Date of publication of application:
15.03.89 Bulletin 89/11

(84) Designated Contracting States:
DE ES FR GB IT SE

(71) Applicant: THE BABCOCK & WILCOX
COMPANY
1010 Common Street P.O. Box 60035
New Orleans Louisiana 70160(US)

(72) Inventor: Mizerak, Dennis Samuel
4770 Locust Lane
Brunswick Ohio 44212(US)

(74) Representative: Cotter, Ivan John et al
D. YOUNG & CO. 10 Staple Inn
London WC1V 7RD(GB)

(54) **Fuse covers.**

(57) A fuse cover comprises a transparent resilient cylindrical member (10) having an axially extending slot (12) therein which extends over the full length of the member. Two pairs of recesses (14) are provided in the slot (12) for engaging a pair of fuse clips (18) mounted to a circuit board (16) and holding a fuse (20) therebetween. The cylindrical member (10) has opposite open ends for ventilation and can be installed over and removed from a fuse (20) without tools and without disturbing the mounting of the fuse.

# FIG.2

EP 0 307 067 A2

## FUSE COVERS

This invention relates to fuse covers.

Fuses are sometimes mounted between fuse clips connected to printed circuit boards. The same circuit boards may carry switches that must be manually switched from time to time. If the switches are mounted too close to the fuse, or fuse clips, a potential electrocution hazard is created. To avoid this hazard, it is advisable to provide a cover over the fuse clips and their fuse. US Patent No. US-A-4 473 268 (Watanabe) discloses a fuse cover having a base enclosure into which the fuse clips are mounted. The fuse is held in a separate cover plate which is used to simultaneously engage the fuse with its clips and cover the enclosure. This fuse cover is relatively complex and large and requires that the fuse clips be disconnected from a circuit board before the cover can be installed.

US-A-4 335 415 (Hooberry) discloses an enclosure for two fuses in an aerial (antenna) lightning arrestor. Again, the fuse clips are mounted on the enclosure.

Additional fuse enclosures are disclosed in US-A-4 563 666 (Borzoni) and US-A-4 599 597 (Rotbart). Again, relatively complex structures are taught.

According to one aspect of the invention there is provided a fuse cover for a fuse connected to a circuit board by at least one connector, the fuse cover comprising a tubular member having opposite open ends and an axially extending slot for receiving the connector while the fuse is in the tubular member.

According to another aspect of the invention there is provided a fuse cover combination comprising a board, a pair of fuse engaging clips spaced apart from each other and connected to the board, a fuse mounted between the clips, and a fuse cover engaged over the fuse and fuse clips, the fuse cover comprising a transparent resilient tubular member having opposite open ends and an axial length which is greater than a length encompassing the fuse and fuse clips, the tubular member having an axially extending slot engaged on opposite sides of the fuse clips.

A preferred embodiment of the invention described in detail hereinbelow comprises a fuse cover which can be installed over a fuse without disturbing its connection to a circuit board to which the fuse is connected. The preferred fuse cover comprises a tubular member having opposite open ends and an axially extending slot for embracing contacts or clips to which the fuse is connected. The tubular member is advantageously transparent so that the fuse can be viewed directly without removing the cover. The open ends of the tubular member allow for airflow to avoid overheating of the fuse. The cover takes up little space on the circuit board and effectively isolates the fuse from surrounding structures. The cover can be installed either by sliding it axially over the fuse contacts or clips or by spreading the tubular member at its slot so that it can be snapped over the fuse. No tools are necessary to install or remove the cover and no modifications need be made to the circuit board. The preferred fuse cover is simple in design, rugged in construction and economical to manufacture.

The invention will now be further described, by way of illustrative and non-limiting example, with reference to the accompanying drawings, in which like references designate like or corresponding parts throughout, and in which:

Figure 1 is a perspective view of a fuse cover embodying the invention;

Figure 2 is a side elevational view of the fuse cover engaged over a fuse, mounted on fuse clips, which are connected to a circuit board; and

Figure 3 is an end elevational view of Figure 2.

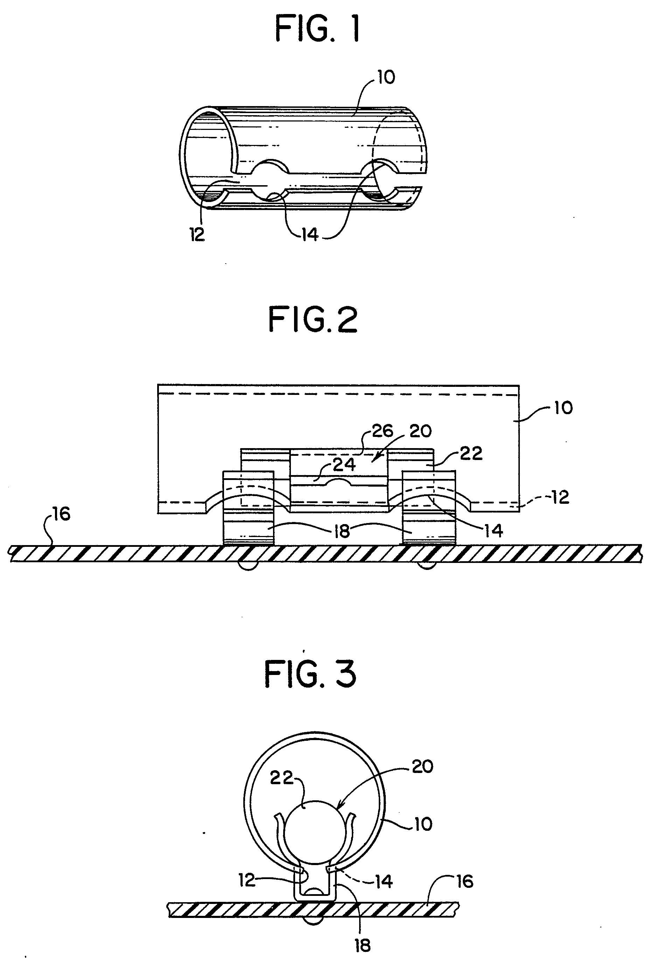

Figure 1 shows a fuse cover made of a one piece tubular member 10 having opposite open ends and an axially extending slot 12 which extends the full length of the member 10. Two pairs of recesses 14, which are preferably curved or circular, are provided along the slot 12, at locations spaced inwardly from the outer open ends of the tubular member 10. The tubular member 10 is preferably made of resilient transparent plastics or other insulating material and is advantageously cylindrical. However, other shapes may be utilised.

Figure 2 shows a circuit board 16 which carries a pair of fuse connectors in the form of metal fuse clips 18 which are spaced apart by a distance approximately equal to the distance between the two pairs of recesses 14 on the tubular member 10. A conventional fuse 20 has opposite metal caps 22 which are snapped into the respective clips 18. A fusible member 24 is electrically connected between the caps 22. If an over current flows between the clips 18, this causes the fusible member 24 to melt.

A transparent enclosure 26, which is advantageously made of glass or ceramic, is mounted between the caps 22 and encloses the fusible member 24.

To install the fuse cover, the fuse cover is slid axially across the clips 18, with the clips aligned with the slot 12, until the recesses 14 embrace the clips 18. Alternatively, the tubular cover member 18 can be snapped down onto the fuse 20. This requires the cover member 10 to be made of resilient material so that the slot 12 can spread to accommodate the fuse 20 and the upper portions of the fuse clips 18 until the fuse cover is snapped into the position shown in Figures 2 and 3.

The fuse cover must have an axial length which is greater than that of the fuse 20, with its clips 18, to avoid inadvertent touching of the fuse from outside of the cover. The cover is also advantageously transparent so that the fuse can be viewed without removing the cover. The axial slot 12 and the open ends of the cover provide adequate air circulation for ventilating the fuse 20 and preventing a build up of heat.

## Claims

1. A fuse cover for a fuse (20) connected to a circuit board (16) by at least one connector (18), the fuse cover comprising a tubular member (10) having opposite open ends and an axially extending slot (12) for receiving the connector (18) while the fuse (20) is in the tubular member (10).

2. A fuse cover according to claim 1, wherein the tubular member (10) is cylindrical and the slot (12) extends the full axial length of the tubular member.

3. A fuse cover according to claim 1 or claim 2, wherein the tubular member (10) is made of resilient transparent insulating material.

4. A fuse cover according to claim 1, wherein the tubular member (10) has at least one pair of recesses (14) in the slot (12) for engagement against the fuse connector (18).

5. A fuse cover according to claim 4, wherein the tubular member (10) is cylindrical and made of transparent insulating material, and the slot (12) extends the full axial length of the tubular member.

6. A fuse cover according to claim 5, wherein the recesses (14) are circular.

7. A fuse cover according to claim 6, including two pairs of recesses (14) in the slot, said pairs of recesses (14) being spaced apart and each pair being spaced inwardly from an open end of the tubular member (10) for engagement around a respective one of a pair of connectors (18) for a fuse (20).

8. A fuse cover combination comprising a board (16), a pair of fuse engaging clips (18) spaced apart from each other and connected to the board (16), a fuse (20) mounted between the clips (18), and a fuse cover engaged over the fuse (20) and fuse clips (18), the fuse cover comprising a transparent resilient tubular member (10) having opposite open ends and an axial length which is greater than a length encompassing the fuse (20) and fuse clips (18), the tubular member (10) having an axially extending slot (12) engaged on opposite sides of the fuse clips (18).

9. A combination according to claim 8, wherein the tubular member (10) is cylindrical.

10. A combination according to claim 9, wherein the tubular member is transparent and resilient.

11. A combination according to claim 10, wherein the tubular member (10) includes two pairs of recesses (14) in the slot (12), the pairs of recesses (14) being spaced apart by an amount substantially equal to the spacing between the clips (18) and each clip (18) being engaged between one of the pairs of recesses (14).

12. A combination according to claim 11, wherein each recess (14) is each curved.

13. A combination according to claim 12, wherein the slot (12) extends the full axial length of the tubular member (10).

14. A combination according to claim 13, wherein the recesses (14) are circular.

# FIG. 1

10

12  14

# FIG.2

26  20
24  22
10
16  12
18  14

# FIG. 3

22  20
10
12  14  16
18